# EUROPÄISCHE PATENTSCHRIFT

(11) **EP 0 321 725 B1**
(45) Veröffentlichungstag und Bekanntmachung des Hinweises auf die Patenterteilung: **26.01.1994**
(21) Anmeldenummer: 88119595.2
(22) Anmeldetag: 24.11.1988
(51) Int. Cl.: H03L 7/18

(54) **Verfahren zum Ermitteln einer Ansteuerspannung eines spannungsgesteuerten Oszillators in einem Phasenregelkreis**
Method for determining the control voltage of a voltage-controlled oscillator in a phase-locked loop
Procédé pour déterminer une tension de commande d'un oscillateur commandé en tension d'une boucle d'asservissement de phase

(30) Priorität: 22.12.1987 DE 3743631
(43) Veröffentlichungstag der Anmeldung: 28.06.1989
(73) Patentinhaber: SIEMENS AKTIENGESELLSCHAFT, 80333 München (DE)
(72) Erfinder: Zwack, Eduard, Dipl.-Ing. (FH), D-8039 Puchheim (DE)

(56) Entgegenhaltungen:
- DE-A- 1 762 746
- DE-A- 2 735 053
- DE-B- 2 735 011
- FR-A- 2 484 104
- FR-A- 2 546 691
- US-A- 4 458 214
- PROCEEDINGS 1979 INTERNATIONAL SYMPOSIUM ON CIRCUITS AND SYSTEMS, Part II, Tokyo, 17-19 Juli 1979, Seiten 804-805; MASATOSHI u.a.: "A microprocessor-controlled Phase-locked loop for Network Synchronization"

## Beschreibung

In digitalen Kommunikationsnetzen werden Taktsignale - im weiteren als Netztaktsignale bezeichnet - entweder separat oder im Informationsfluß enthalten an die einzelnen Netzkomponenten, wie z. B. Vermittlungseinrichtungen, übermittelt. In den Vermittlungseinrichtungen, wie z. B. private Nebenstellenanlagen, werden die empfangenen Netztaktsignale meist nicht direkt zur Taktsteuerung der einzelnen Komponenten der Vermittlungseinrichtung herangezogen, da bei Ausfall der Netztaktsignale die Vermittlungseinrichtungen nicht mehr steuerbar wären bzw. einen undefinierten Betriebszustand einnehmen würden. Aus diesem Grunde werden die empfangenen Netztaktsignale auf einen Phasenregelkreis geführt, in dem interne Taktsignale gebildet und an die einzelnen Komponenten einer Teilnehmerstation übermittelt werden.

In einem derartigen Phasenregelkreis müssen folgende Funktionen realisiert sein:
- Erzeugen von internen Taktimpulsen in einem internen spannungsgesteuerten Oszillator - im weiteren mit VCO-Oszillator bezeichnet,
- Anpassen der Frequenz der Netztaktsignale an die Frequenz der internen Taktsignale und
- Steuern des internen VCO-Oszillators derart, daß die Phasen der Netztaktsignale und der internen Taktsignale übereinstimmen, um
   1. die vom Kommunikationsnetz übermittelten Informationen direkt in der Vermittlungseinrichtung verarbeiten zu können und
   2. bei Ausfall der Netztaktsignale einen Phasensprung in einem der internen Taktsignale zu vermeiden.

Neben integrierten Schaltkreisen werden in Phasenregelkreisen in zunehmendem Maße Mikroprozessoren mit geeigneter Peripherie eingesetzt. Ein Phasenregelkreis, der einerseits die vorhergehend erläuterten Funktionsmerkmale aufweist und andererseits mit einem Mikroprozessorsystem ausgestattet ist, ist aus der Druckschrift "Proceedings of 1979 ISCAS", Seiten 804 bis 805, bekannt. Dieser Phasenregelkreis besteht aus einem digitalen Phasenkomparator, einem digital gesteuerten Oszillator, einer Steuereinrichtung und zwei Dividiereinrichtungen. In der ersten Dividiereinrichtung wird die Frequenz der zugeführten Netztaktsignale reduziert. Diese in der Frequenz veränderten Netztaktsignale werden anschließend an eine digitale Phasenvergleichseinrichtung weitergeleitet. Die Phasenvergleichseinrichtung ist mit einem Phasenvergleicher und einem Zähler versehen. An die Phasenvergleichseinrichtung werden zusätzlich über die zweite Dividiereinrichtung die internen, in einem digital gesteuerten Oszillator erzeugten Taktimpulse geführt. Die Dividiereinrichtungen sind so dimensioniert, daß die Frequenz der am Phasenvergleicher anliegenden Netztaktsignale mit der der internen Taktsignale annähernd übereinstimmt. Im Phasenvergleicher werden die beiden Taktsignale hinsichtlich ihrer Phasenlage verglichen; das Vergleichsergebnis wird dem Zähler zugeführt. Außerdem werden die internen Taktsignale an den Zähleingang des Zählers übermittelt. Weichen die Phasen der beiden Taktsignale voneinander ab, so werden interne Taktsignale in den Zähler eingelesen und gezählt. Das Zählergebnis wird an eine durch ein Mikroprozessorsystem realisierte Steuereinrichtung übergeben. In dieser Steuereinrichtung werden die die Phasenabweichungen repräsentierenden Zählergebnisse ermittelt, gefiltert - Tiefpaßfilter - und als digitale Spannungswerte an einen extern angeordneten D/A-Wandler geleitet. Die vom D/A-Wandler abgegebenen analogen Ausgangsspannungen steuern einen VCO-Oszillator derart, daß die vom VCO-Oszillator erzeugten internen Taktsignale hinsichtlich ihrer Phasenlage mit den Netztaktsignalen übereinstimmen. VCO-Oszillator und D/A-Wandler bilden zusammen den digital gesteuerten Oszillator.

Aus der genannten Druckschrift geht hervor, daß die einzelnen Systemkomponenten des Regelkreises, wie Phasenvergleicher, Zähler, Oszillator und D/A-Wandler, nicht in die Steuereinrichtung integriert sind. Die Druckschrift enthält darüber hinaus keine Hinweise, wie die einzelnen Hardware-Komponenten, insbesondere der Phasenvergleicher, realisierbar sind. Des weiteren kann der Phasenregelkreis nur durch Ändern bzw. Tauschen von Hardware-Komponenten an unterschiedliche Netztakt- und VCO-Taktsignalfrequenzen angepaßt werden.

Aus einer weiteren Druckschrift DE-A-27 35 053 ist ein Phasenregelkreis mit einer digitalen Filterstufe bekannt. Die digitale Filterstufe weist zwei Zählstufen auf, in denen in Abhängigkeit von der Impulsdauer von in einem Phasendetektor gebildeten Phasendifferenzsignalen die in einem separaten Zähltaktoszillator gebildeten Taktsignale gezahlt werden. Die gespeicherten Zählerstände der ersten Zählstufe stellen hierbei die Regelgröße für den Phasenregelkreis dar und werden einem nachgeschalteten Digital/Analog-Wandler zugeführt.

Basierend auf dem Einsatz eines Mikroprozessorsystems in einem Phasenregelkreis besteht die Aufgabe der Erfindung darin, diesen Phasenregelkreis so auszugestalten, daß eine einfache Anpassung an unterschiedliche Netztakt- und VCO-Taktsignalfrequenzen ermöglicht wird und möglichst alle Systemkomponenten bzw. deren Funktionen im Mikroprozessorsystem realisierbar sind.

Die Aufgabe der Erfindung wird ausgehend von dem im Oberbegriff des Anspruchs 1 definierten Verfahren durch die kennzeichnenden Merkmale des Anspruchs 1 gelöst.

Die serienschaltung des Zählers, des Registers und der Arithmetikeinrichtung bewirkt eine sehr einfache Anpassung an unterschiedliche Frequenzen der beiden Taktsignale, da die Komponenten des Phasenregelkreises so dimensionierbar sind -z.B. Zähler- und Registerlange -, daß für unterschiedlichste Taktsignalfrequenzen eine die Phasenabweichung der beiden Taktsignale repräsentierende Information ermittelt und ein Ansteuerspannungssignal für den spannungsgesteuerten Oszillator gebildet werden kann.

Ein weiterer Vorteil der Serienschaltung des Zählers, des Registers und der Arithmetikeinrichtung ist in ihrer sehr einfachen Realisierbarkeit in einem Mikroprozessorsystem - Zählen, Speichern, einfache Rechenoperationen - zu sehen. Dies bedeutet, daß der Phasenregelkreis weitgehend in einem Mikroprozessorsystem realisiert werden kann, da - wie eingangs bereits erläutert - das Integrieren von Tiefpaßfilterfunktionen und PI-Filterfunktionen per Programm in ein Mikroprozessorsystem bekannt ist.

Die Regelgenauigkeit des Phasenregelkreises hängt im wesentlichen von der Frequenz der Taktsignale, von der Dauer der Auswerteintervalle und von den darauf abgestimmten Zeitkostanten bzw. Regelgeschwindigkeiten der nachgeschalteten Filter und Integrierer ab. Eine höhere Frequenz der Taktsignale bewirkt ein höheres Auflösungsvermögen bei der Ermittlung der Phasenabweichungen. Je höher die Auflösung - d. h. je genauer die ermittelte Phasenabweichung je Auswertedauer -, desto genauer kann die Ansteuerspannung ermittelt werden. Zu beachten ist hierbei, daß insbesondere die Zeitkonstante des Tiefpaßfilter möglichst klein zu halten ist. Dies erfolgt derart, daß in Abhängigkeit von der Frequenz der Taktsignale die Auswerteintervalldauer und die Zeitkonstanten bzw. Regelgeschwindigkeiten der Filter und Integrierer aufeinander abgestimmt sind - siehe Anspruch 2.

Gemäß einer vorteilhaften Weiterbildung der Ausgestaltung der Erfindung nach Anspruch 2 sind die Komponenten des Phasenregelkreises von einer zentralen Steuerung steuer- und überwachbar. Dies trifft vor allem für eine solche Implementierung des erfindungsgemäßen Verfahrens in ein Mikroprozessorsystem zu, bei der alle Programmteile vorteilhaft von einer zentralen Steuerung koordiniert, überwacht und inbetriebgenommen werden.

Besonders hervorzuheben sind die vielfältigen Fehlererkennungs- und Fehlermelde- bzw. Anzeigemöglichkeiten, die aufgrund der Realisierung der Programme möglich sind. Beispielsweise kann das Vorhandensein der Referenz- und Taktsignale überwacht werden - siehe Anspruch 4. Fallen die vom Oszillator kommenden Taktsignale aus, so kann dieser Ausfall gemeldet bzw. angezeigt werden. Des weiteren kann beispielsweise das Anlegen von Referenztaktsignalen, auf deren Frequenz der Phasenregelkreis nicht synchronisierbar ist, erkannt und gemeldet bzw. angezeigt werden - siehe Anspruch 5. Da die Vermittlungseinrichtungen meist über mehrere den Referenztakt übermittelnde Leitungen mit dem digitalen Kommunikationsnetz verbunden sind, kann nach Ausfall einer der Referenztaktsignale meist auf redundant bereitgestellte Referenztaktsignale umgeschaltet werden.

Die in Anspruch 1 genannte Bedingung - die Frequenz der Zeitintervall-Taktsignale ist niedriger als die Frequenz der Taktsignale - wird vorteilhafterweise derart erfüllt, daß die Intervall-Taktsignale mittels einer in ihrem Divisionsverhältnis variierbaren Dividiereinrichtung aus den Referenztaktsignalen gewonnen werden - siehe Anspruch 6. Diese Dividiereinrichtung kann entweder per Programm im Mikroprozessorsystem, das den Phasenregelkreis enthält, oder als Hardware-Einrichtung realisiert werden. Die Art der Realisierung hängt im wesentlichen von der Frequenz der Referenztaktsignale ab. Bei hohen Frequenzen, d. h. höher als die maximale Verarbeitungsgeschwindigkeit des Mikroprozessorsystems, ist eine Hardware-Ausführung der Dividiereinrichtung erforderlich. Liegt die Frequenz unter der maximalen Verarbeitungsgeschwindkeit des Mikroprozessorsystems, so ist eine Hardware- oder Software-Ausführung möglich. Die Software-Ausführung ist jedoch zu bevorzugen, da durch Ändern der Programme eine einfache Anpassung an unterschiedlichste Betriebsbedingungen des Phasenregelkreises vorzunehmen ist und sie der gestellten Aufgabe, möglichst viele Komponenten des Phasenregelkreises in ein Mikroprozessorsystem zu integrieren besser gerecht wird.

Das Variieren des Divisionsverhältnisses der Dividiereinrichtung ist sowohl bei einer Hardware- als auch einer Software-Ausführung besonders vorteilhaft von der zentralen Steuerung durchzuführen - d. h. per Programmeingabe -, da dadurch eine Einstellung des Divisionsverhältnisses durch extern angeordnete mechanische Schaltmittel vermeidbar ist - siehe Anspruch 4. Bei einer Hardware-Ausführung der Dividiereinrichtung, z. B. als eine Frequenzteilerkette mit variablem Teilungsfaktor, kann über zusätzliche Steuerverbindungen zwischen Mikroprozessorsystem und Frequenzteilerkette der Teilungsfaktor und damit das Divisionsverhältnis eingestellt werden.

Eine besonders vorteilhafte Realisierung bezüglich der Dividiereinrichtung stellt das automatische Ermitteln und Einstellen des Divisionsverhältnisses der Dividiereinrichtung dar. Hierbei wird die Frequenz der dem Phasenregelkreis zugeführten Referenztaktsignale ermittelt und das Divisionsverhältnis mit Hilfe der zentralen Steuereinrichtung bestimmt und die Dividiereinrichtung entsprechend eingestellt - siehe Anspruch 8. Die Frequenz der Referenztaktsignale wird mit Hilfe einer ebenfalls per Programm realisierbaren Frequenzmeßeinrichtung gemessen. Das Divisionsverhältnis kann hierbei so bestimmt werden, daß jeweils Zeitintervall-Taktsignale gleicher Dauer am Ausgang der Dividiereinrichtung vorliegen. Es können auch abweichende Zeitintervall-Taktsignale durch das Divisionsverhältnis bestimmt werden, jedoch sind dann gegebenenfalls die Auswerteintervalldauer und die Zeitkonstanten bzw. Regelgeschwindigkeiten der folgenden Tiefpaß- und PI-Filter anzupassen.

Aufgrund der Konzeption des erfindungsgemäßen Verfahrens und der damit erreichten hohen Anpassungsfähigkeit an unterschiedliche Taktsignalfrequenzen ist das Einfügen von zusätzlichen Komponenten bzw. Funktionen des verwendeten Phasenregelkreises zwischen die bereits vorhandenen möglich. Besonders vorteilhaft kann dieser Phasenregelkreis zum Bilden einer Frequenzvervielfacheinrichtung oder eines hochkonstanten spannungsgesteuerten Oszillators - siehe Anspruch 9 - herangezogen werden. Weitere Einrichtungen können beispielsweise durch Einfügen von Laufzeitgliedern, zusätzlichen analogen Komponenten oder zusätzlichen Filterfunktionen bei entsprechender Anpassung des Phasenregelkreises gebildet werden.

Wie bereits erläutert, sind alle Komponenten des Phasenregelkreises mit Ausnahme des spannungsgesteuerten Oszillators in einem Mikroprozessorsystem realisierbar - siehe Anspruch 10.

Die damit verbundene Realisierung per Programm - siehe Anspruch 11 - erhöht die Anpassungsfähigkeit des Phasenregelkreises an unterschiedlichste Bedingungen. Hierunter ist beispielsweise eine Anpassung an unterschiedliche Taktfrequenzen - auch während des Betriebes bei Ausfall der Referenztaktsignale und Umschaltung auf Referenztaktsignale anderer Frequenz - zu verstehen. Des weiteren ist eine Anpassung an unterschiedliche Oszillator-Regelgeschwindigkeiten - z. B. in Abhängigkeit von der Qualität der Taktsignale - und an unterschiedliche Oszillatoren - hinsichtlich der Ansteuerspannungsbedingungen - möglich. Die Anpassung kann während des Betriebes automatisch - hierfür sind zusätzliche Detektoren, wie beispielsweise eine Frequenzmeßeinrichtung, einzufügen - oder manuell - z. B. durch Laden eines Programms - durch geeignete Programmänderungen erfolgen.

Nach einer weiteren vorteilhaften Ausgestaltung der Erfindung gemäß Anspruch 12 ist das Mikroprozessorsystem durch einen 1 Chip-Mikroprozessor mit integriertem D/A-Wandler realisierbar. Dies stellt hinsichtlich Platzbedarf und Wirtschaftlichkeit eine besonders vorteilhafte Ausgestaltung der Erfindung dar, da zum Bilden des Phasenregelkreises dem 1-Chip Mikroprozessor lediglich der spannungsgesteuerte Oszillator und gegebenenfalls - falls die Referenztakt- oder die Oszillator-Taktsignalfrequenz wesentlich über der Verarbeitungsgeschwindigkeit des Mikroprozessors liegt - eine in ihrem Divisionsverhältnis variierbare Dividiereinrichtung dem 1 Chip-Mikroprozessor zugeordnet werden muß.

Nach einer vorteilhaften Ausgestaltung der Erfindung gemäß Anspruch 13 sind die den Komponenten des Phasenregelkreises zugeordneten Funktionen überwiegend in einem kundenspezifizierten, integrierten Schaltkreis realisierbar. Hierfür eignen sich besonders die integrierten Schaltkreise in ASIC (Application Specified Integrated Circuit)-Technik. Diese Schaltkreise enthalten ein 1 Chip-Mikroprozessorsystem und einen Bereich, der durch vom Kunden spezifizierte Hardware belegt werden kann. Dieser Schaltkreis stellt bei hohen Frequenzen der Taktsignale die vorteilhafteste Realisierung der Erfindung dar, da diejenigen Komponenten des Phasenregelkreises, die die Taktsignale verarbeiten, in Hardware, und diejenigen Komponenten des Phasenregelkreises, die die Berechnung der Phasenabweichungen und der Ansteuersignale des Oszillators vornehmen, in Software realisierbar sind.

Im folgenden werden Realisierungsmöglichkeiten und Ausführungsbeispiele des erfindungsgemäßen Verfahrens bzw. der erfindungsgemäßen Anordnung anhand von Blockschaltbildern und eines Ablaufdiagrammes näher erläutert.

Dabei zeigen:
- Fig. 1: ein Blockschaltbild eines Phasenregelkreises,
- Fig. 2: ein Ablaufdiagramm zur Erläuterung des Blockschaltbildes nach Fig. 1,
- Fig. 3: eine Frequenzvervielfacheinrichtung, bzw. hochstabiler spannungsgesteuerter Oszillator, der mit dem erfindungsgemäßen Phasenregelkreis gebildet sind.

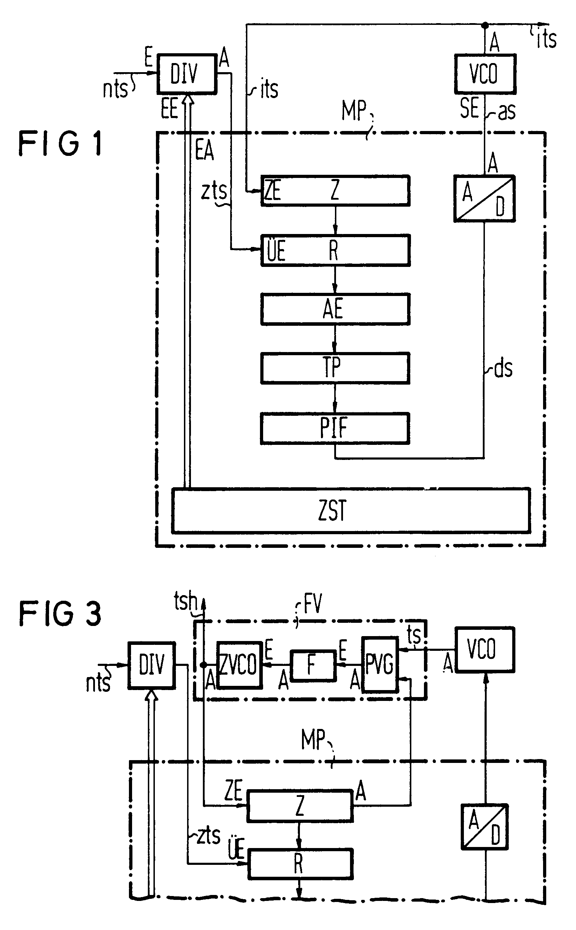

Fig. 1 zeigt die zur Erläuterung erforderlichen Komponenten eines Phasenregelkreises. Es sei angenommen, daß der Phasenregelkreis durch einen spannungsgesteuerten Oszillator VCO - im weiteren mit Oszillator bezeichnet -, einer Dividiereinrichtung DIV sowie einen 1 Chip-Mikroprozessor MP gebildet ist. Der Oszillator VCO besteht beispielsweise aus einer integrierten Quarzoszillatorschaltung sowie einer Ziehschaltung, mit der die Oszillatorfrequenz in vorgegebenen Grenzen regelbar ist. Da die Ziehschaltung üblicherweise durch Kapazitätsdioden realisiert ist, wird eine Frequenzänderung durch Variieren einer an einen Spannungseingang SE des Oszillators VCO angelegten Gleichspannung erreicht. Diese Gleichspannung wird im weiteren mit Ansteuerspannung as bezeichnet. Die Dividiereinrichtung DIV enthält eine aus integrierten Schaltkreisen gebildete Teilerkette, an deren Einstelleingänge EE der Teilungsfaktor bzw. das Divisionsverhältnis eingestellt wird. An einen Eingang E der Dividiereinrichtung DIV werden Netztaktsignale nts geführt. Diese Netztaktsignale nts sind beispielsweise aus über ein Kommunikationsnetz übermittelten Taktinformationen mittels geeigneter Einrichtungen abgeleitet.

Im 1 Chip-Mikroprozessor MP ist eine Zähleinrichtung Z, ein Register R, eine Arithmetikeinrichtung AE, ein Tiefpaß TP, ein PI-Filter PIF und ein D/A-Wandler hintereinander geschaltet. Im Sinne der Inbetriebnahme, der Steuerung und Überwachung der Komponenten enthält der 1 Chip-Mikroprozessor MP eine zentrale Steuereinrichtung ZST. Mit Hilfe dieser zentralen Steuereinrichtung ZST wird über die Einstellausgänge EA, die mit den Einstelleingängen EE der Dividiereinrichtung DIV verbunden sind, der Teilungsfaktor der in der Dividiereinrichtung DIV realisierten Teilerkette - beispielsweise per Programmeingabe - eingestellt. Ein Ausgang A der Dividiereinrichtung DIV ist über eine entsprechende Verbindung mit einem Übernahmeeingang ÜE des Registers R verbunden. Ein Ausgang A des D/A-Wandlers D/A ist auf den Spannungseingang SE des Oszillators VCO geführt. An dem Ausgang des Oszillators VCO stehen digitale Taktsignale zur Verfügung, die einerseits als interne Taktsignale its an weiterverarbeitende Einrichtungen geführt werden und andererseits über eine entsprechend angeordnete Verbindung zu einem Zähleingang ZE des Zählers Z gelangen. Alle Einrichtungen im 1 Chip-Mikroprozessor MP sind durch Programme - auf den jeweiligen 1 Chip-Mikroprozessor MP abgestimmt - realisiert. Besonders vorteilhaft ist der Einsatz eines 1 Chip-Mikroprozessors MP mit integriertem D/A-Wandler D/A. Hierdurch kann der Anwenderprogrammier- bzw. Entwicklungsaufwand verringert werden.

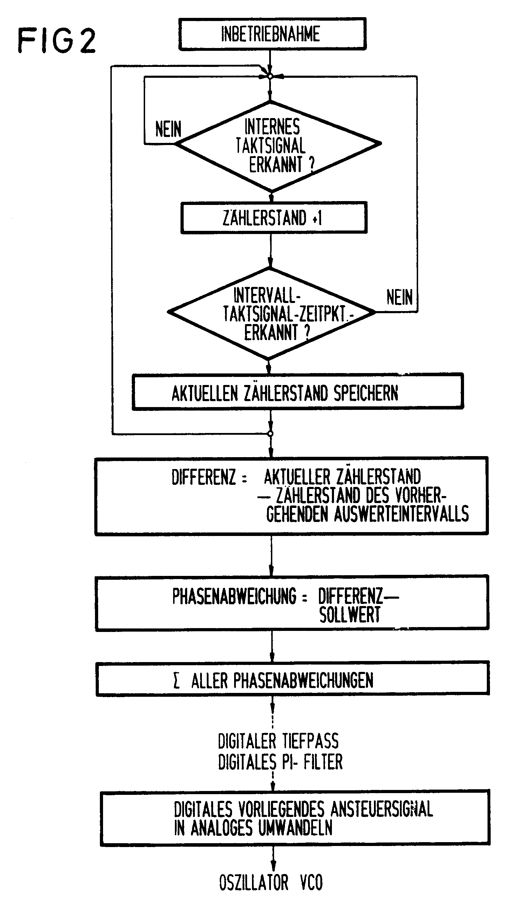

Im folgenden werden mit Hilfe des in Fig. 2 aufgezeigten Ablaufdiagramms die einzelnen Funktionen der Komponenten des Phasenregelkreises und deren Zusammenwirken erläutert. Nach dem Einschalten des Phasenregelkreises - d. h. Anlegen der Versorgungsspannung - wird mit Hilfe der zentralen Steuereinrichtung ZST der Phasenregelkreis inbetriebgenommen. Hierzu steuert die zentrale Steuereinrichtung ZST alle Komponenten des Phasenregelkreises - insbesondere die Komponenten im 1 Chip-Mikroprozessor MP - in einen definierten Ausgangszustand, wie z. B. Register R zurücksetzen und Rechenoperationsparameter eingeben, usw..

Nach dem Erkennen jedes vom Oszillator VCO abgegebenen und an den Zähleingang ZE der Zähleinrichtung Z geführten internen Taktsignals its in der Zähleinrichtung Z wird der Zählerstand des Zählers Z um eins erhöht. Dieser Vorgang, Erkennen des internen Taktsignals its und Erhöhen des Zählerstandes wird solange wiederholt, bis am Übernahmeeingang ÜE des Registers R ein Informationswechsel festgestellt wird. Ein derartiger Informationswechsel ist beispielsweise der Übergang von TTL-Highzu TTL-Low-Spannungspegel. Wird nun ein Informationswechsel der Zeitintervall-Taktsignale zts festgestellt, so wird der aktuell in der Zähleinrichtung Z vorliegende Zählerstand in das Register R übernommen und dort gespeichert. Anschließend wird das Erkennen der internen Taktsignale its und das jeweilige Erhöhen des Zählerstandes um eins fortgesetzt. Gleichzeitig wird der gespeicherte Zählerstand an die Arithmetikeinrichtung AE weitergeleitet. In der Arithmetikeinrichtung AE werden folgende Berechnungen in nachstehender Reihenfolge durchgeführt:
- Ermitteln des Auswerteintervalls, wenn die Dauer eines Zeitintervall-Taktsignals zts nicht der Dauer eines Auswerteintervalls entspricht,
- Ermitteln der Differenz des aktuellen Zählerstandes zu dem Zählerstand des vorhergehenden Auswerteintervalls,
- Ermitteln der aktuellen Phasenabweichung durch Subtrahieren eines Sollwertes von der ermittelten Zählerstanddifferenz (der Sollwert repräsentiert das Ansteuersignal as des Oszillators VCO bei dessen Nennfrequenz),
- Aufsummieren aller je Auswerteintervall ermittelten Phasenabweichungen.

Die in der Arithmetikeinrichtung AE ermittelten Phasenabweichinformationen werden im Sinne einer Gleichrichtung über ein digitales Tiefpaßfilter TP und im Sinne einer spannungsmäßigen und Regelgeschwindigkeitsanpassung über ein digitales PI-Filter PIF geführt. Die nun digital vorliegenden Ansteuersignale ds für den Oszillator VCO werden in einem D/A-Wandler in analoge Ansteuersignale as umgesetzt und über einen entsprechenden Ausgang des 1 Chip-Mikroprozessorsystems MP an den Spannungseingang SE des Oszillators VCO geleitet.

Fig. 3 zeigt eine Einrichtung, die sowohl als Frequenzvervielfacher als auch als hochkonstanter spannungsgesteuerter Oszillator einsetzbar ist. Diese Einrichtung ist mit einem gemäß Fig. 1 und Fig. 2 realisierten Phasenregelkreis ausgestattet. Hierbei entsprechen die Anordnungen bzw. entsprechen die Funktionen der im 1 Chip-Mikroprozessorsystem MP realisierten Komponenten der bzw. denen in Fig. 1 und Fig. 2 erläuterten. Die Zeitintervall-Taktsignale zts werden entsprechend Fig. 1 mittels einer Dividiereinrichtung DIV aus den Netztaktsignalen nts gewonnen und an den Übernahmeeingang ÜE des Registers R geleitet. Ebenso wird entsprechend Fig. 1 der Oszillator VCO an den 1 Chip-Mikroprozessor MP angeschlossen und von diesem gesteuert. Der wesentliche Unterschied zu Fig. 1 besteht in dem Einfügen eines Frequenzvervielfachers FV zwischen den Ausgang des Oszillators VCO und den Zählereingang ZE des Zählers Z. Der Frequenzvervielfacher FV ist durch eine Serienschaltung einer zusätzlichen Phasenvergleichseinrichtung PVG, eines Tiefpaßfilters F und eines zusätzlichen, spannungsgesteuerten Oszillators ZVO gebildet. Hierbei ist der Ausgang des zusätzlichen, spannungsgesteuerten und eine höhere Frequenz aufweisenden Oszillators ZVCO mit dem Eingang ZE des Zählers Z, der Ausgang A des Oszillators VCO mit einem Eingang der Phasenvergleichseinrichtung PVG und der verbleibende Eingang der Phasenvergleichseinrichtung PVG mit dem bisher nicht genutzten Ausgang A des Zählers Z verbunden. Diese Einrichtung ist nun sowohl als Frequenzvervielfacheinrichtung als auch als hochkonstanter, spannungsgesteuerter Oszillator zu verwenden. Bei Einsatz als Frequenzvervielfacheinrichtung stehen die Taktsignale tsh mit höherer bzw. vervielfachter Frequenz am Ausgang des zusätzlichen Oszillators ZVCO zur Verfügung und können beispielsweise als Taktsignale zu weiterverarbeitenden Einrichtungen einer Vermittlungseinrichtung geführt werden. Durch die Frequenzerhöhung der Oszillatortaktsignale its - wie bereits erläutert - wird die Regelgenauigkeit des Phasenregelkreises erhöht. Hierdurch wird der Oszillator VCO genauer bzw. präziser gesteuert. Wird nun zusätzlich ein an sich bereits hochstabiler Oszillator VCO verwendet, so ist dieser hinsichtlich seiner Frequenz ebenfalls sehr präzise regelbar, wodurch die Einrichtung als hochgenauer, spannungsgesteuerter Oszillator einsetzbar ist. Eine weitere, jedoch nicht dargestellte Maßnahme, die Regelgenauigkeit des Phasenregelkreises zu erhöhen, ist das Einfügen einer Laufzeiteinrichtung anstelle des Frequenzvervielfachers. Hierbei kann zu Zeitintervallen, die kleiner sind als ein Zeitintervall eines Taktimpulses its, das Auftreten eines Polaritätswechsels der Zeitintervall-Taktsignale bzw. Referenztaktsignale zti festgestellt werden. Diese zusätzlich gewonnene Information wird zusätzlich in die Berechnung der Phasenabweichung einbezogen. Voraussetzung für das Anwenden dieser Maßnahme sind jedoch rauscharme Netztaktsignale nts, die beispielsweise vorliegen, wenn diese von einem ersten Phasenregelkreis zu einem zweiten Phasenregelkreis, der als Ersatzregelkreis vorgesehen ist, übermittelt werden.

## Patentansprüche

1. Verfahren zum Ermitteln einer Ansteuerspannung (as) eines spannungsgesteuerten Oszillators (VCO) in einem Phasenregelkreis, in dem digitale Referenztaktsignale (nts) hinsichtlich ihrer Phasenlage mit aus Oszillatortaktsignalen gewonnenen Taktsignalen (its) verglichen und in einer Prozessoreinrichtung (MP) mittels des Phasenvergleichsergebnisses digitale Oszillator-Ansteuersignale gebildet werden, die gleichgerichtet, integriert und anschließend über einen Digital/Analog-Wandler (A/D) in eine analoge Oszillator-Ansteuerspannung (as) umgesetzt werden,
**dadurch gekennzeichnet,**
daß die Taktsignale (its) in einer Zähleinrichtung (Z), der ein Register (R) nachgeschaltet ist, gezählt werden, daß aus den Referenztaktsignalen gewonnene, eine niedrigere Frequenz als die Taktsignale (its) aufweisende Zeitintervall-Taktsignale (zts) an einen Übernahmeeingang (ÜE) des Registers (R) geführt werden, daß zu durch die Zeiterintervall-Taktsignale (zts) definierten Zeitpunkten ein aktuell vorliegender Zählerstand in das Register (R) übernommen und gespeichert wird, daß der gespeicherte Zählerstand einer Arithmetikeinrichtung (AE) zugeführt wird und in dieser in jedem eine wahlbare Anzahl von Zeitintervall-Taktsignalen (zts) repräsentierenden Auswerteintervall die Differenz des aktuellen Zählerstandes und des Zählerstandes des vorhergehenden Auswerteintervalls gebildet und mit einem die Ansteuerspannung (as) bei Nennfrequenz des Oszillators repräsentierenden Sollwert verglichen wird und daß die Abweichungen vom Sollwert aller Auswerteintervalle aufsummiert und einem digitalen, die aufsummierten Abweichungen gleichrichtenden Tiefpaß (TP) zugeführt werden.

2. Verfahren nach Anspruch 1,
**dadurch gekennzeichnet,**
daß in Abhängigkeit von der Frequenz der Taktsignale (its) die Auswerteintervalldauer und die Zeitkonstanten bzw. Regelgeschwindigkeiten der Filter und Integrierer aufeinander abgestimmt sind.

3. Verfahren nach Anspruch 1,
**dadurch gekennzeichnet,**
daß die Komponenten des Phasenregelkreises zumindest teilweise von einer zentralen Steuereinrichtung (ZST) steuer- und überwachbar sind.

4. Verfahren nach einem der vorhergehenden Ansprüche,
**dadurch gekennzeichnet,**
daß mit Hilfe der zentralen Steuereinrichtung (ZST) das Vorhandensein der Referenz- und Taktsignale (nts, its) überwacht wird und daß ein Ausfall von Taktsignalen gemeldet bzw. angezeigt wird.

5. Verfahren nach einem der vorhergehenden Ansprüche,
**dadurch gekennzeichnet,**
daß mit Hilfe der Steuereinrichtung (ZST) das Zuordnen von Referenztaktsignalen (nts), auf deren Frequenz der Phasenregelkreis nicht synchronisierbar ist, erkannt und gemeldet bzw. angezeigt wird.

6. Verfahren nach einem der vorhergehenden Ansprüche,
**dadurch gekennzeichnet,**
daß die Zeitintervall-Taktsignale (zts) mittels einer in ihrem Divisionsverhältnis variierbaren Dividiereinrichtung (DIV) aus den Referenztaktsignalen (nts) gewonnen werden.

7. Verfahren nach einem der vorhergehenden Ansprüche,
**dadurch gekennzeichnet,**
daß das Divisionsverhältnis der Dividiereinrichtung (DIV) mit Hilfe der zentralen Steuereinrichtung variierbar ist.

8. Verfahren nach einem der vorhergehenden Ansprüche,
**dadurch gekennzeichnet,**
daß die Frequenz der Referenztaktsignale (nts) mit Hilfe einer Frequenzmeßeinrichtung ermittelt wird und daß in Abhängigkeit von der Höhe der ermittelten Frequenz mit Hilfe der zentralen Steuereinrichtung (ZST) das Divisionsverhältnis für die Dividiereinrichtung (DIV) bestimmt und eingestellt wird.

9. Verfahren nach Anspruch 1,
**dadurch gekennzeichnet,**
daß die Taktsignale im Sinne des Einsatzes des Phasenregelkreises als hochkonstanter spannungsgesteuerter Oszillator oder Frequenzvervielfacheinrichtung aus über eine Phasenvergleichseinrichtung (PV) sowie ein zu dieser in Reihe geschaltetes Tiefpaßfilter (F) und einen zusätzlichen spannungsgesteuerten Quarzoszillator (ZVCO) geführten Oszillatortaktsignalen (its) gewonnen werden, wobei der Ausgang (A) der Zähleinrichtung (Z) mit einem Vergleichereingang (E) der Phasenvergleichseinrichtung (PV) verbunden ist.

10. Anordnung zum Durchführen des Verfahrens nach einem der Ansprüche 1 bis 9,
**dadurch gekennzeichnet,**
daß der Phasenregelkreis durch
- einen die Taktsignale (its) erzeugenden, und an seinem Ausgang (A) die Taktsignale (its) bereitstellenden, spannungsgesteuerten Oszillator (VCO),
- eine die Taktsignale (its) zählende Zähleinrichtung (Z), die hierzu über ihren Zähleingang (ZE) mit dem Ausgang (A) des spannungsgesteuerten Oszillators (VCO) verbunden ist,
- einem dem Zähler (Z) nachgeschalteten Register (R), in das bei zu durch die Zeitintervall-Taktsignale (zts) definierten Zeitpunkten ein aktuell vorliegender Zählerstand des Zählers (z) übernommen und gespeichert wird, wobei die Zeitintervall-Taktsignale (zts) an seinem Übernahmeeingang (ÜE) zugeführt werden,
- eine dem Register (R) nachgeschaltete Arithmetikeinrichtung (AE), in der in jedem eine wahlbare Anzahl von Zeitintervall-Taktsignalen (zts) repräsentierenden Auswerteintervall die Differenz des zugeführten aktuellen und des vorhergehenden Auswerteintervalls gebildet und mit einem die Ansteuerspannung (as) bei Nennfrequenz des Oszillators (VCO) repräsentierenden Sollwert verglichen wird,
- einen der Arithmetikeinrichtung (AE) nachgeschalteten digitalen Tiefpaß (TP), in dem die übermittelten, aufsummierten Differenzen der Zählerstande gleichgerichtet werden,
- ein dem digitalen Tiefpaß (TP) nachgeschalteten PI-Filter (PIF), in dem die gleichgerichteten, aufsummierten Differenzen der Zählerstände integriert werden,
- ein dem PI-Filter (PIF) nachgeschalteten Analog/Digital-Wandler (D/A), in dem die integrierten, aufsummierten, gleichgerichteten Differenzen der Zählerstände (DS) in eine analoge Oszillatoransteuerspannung (as) umgesetzt werden, wobei der Ausgang (A) des Analog/Digital-Wandlers (A/D) mit dem Spannungseingang (SE) des spannungsgesteuerten Oszillators (VCO) verbunden ist,
- ein die Frequenz der Referenztaktsignale (nts) ändernde Dividiereinrichtung (DIV), an deren Eingang (E) die Referenztaktsignale (nts) und über deren Ausgang (A) die dividierten Referenztaktsignale (nts) repräsentierende Zeitintervall-Taktsignale (zts) an den Übernahmeeingang (ÜE) des Registers (R) geführt werden,
- und eine zentrale Steuerung (ZST), mit deren Hilfe über in der Dividiereinrichtung (DIV) angeordneten Einstelleingänge (EE) der Teilungsfaktor und die definierten Ausgangszustände in den Komponenten des Phasenregelkreises eingestellt werden.

11. Anordnung nach Anspruch 10,
**dadurch gekennzeichnet,**
daß die den Komponenten des Phasenregelkreises zugeordneten Funktionen überwiegend in einem Mikroprozessorsystem (MP) durch Programme realisierbar sind.

12. Anordnung nach Anspruch 11,
**dadurch gekennzeichnet,**
daß das Mikroprozessorsystem (MP) durch einen 1 Chip-Mikroprozessor (MP) mit integriertem A/D-Wandler realisierbar ist.

13. Anordnung nach Anspruch 10,
**dadurch gekennzeichnet,**
daß die den Komponenten des Phasenregelkreises zugeordneten Funktionen überwiegend in einem kundenspezifizierten, integrierten Schaltkreis realisierbar sind.

## Claims

1. Method for determining a control voltage (as) of a voltage-controlled oscillator (VCO) in a phase-locked loop, in which digital reference clock signals (nts) are compared with respect to their phase angle with clock signals (its) obtained from oscillator clock signals and in a processor device (MP), the phase comparison result is used for forming digital oscillator control signals which are rectified, integrated and then converted into an analog oscillator control voltage (as) via a digital/analog converter (A/D), characterized in that the clock signals (its) are counted in a counting device (Z) which is followed by a register (R), in than time interval clock signals (zts) obtained from the reference clock signals and exhibiting a lower frequency than the clock signals (its) are conducted to a transfer input (ÜE) of the register (R), in that a currently present count is transferred into the register (R) at times defined by the time interval clock signals (zts) and is stored, in that the stored count is supplied to an arithmetic unit (AE) and in the latter, in each evaluating interval representing a selectable number of time interval clock signals (zts), the difference between the current count and the count of the preceding evaluating interval is formed and is compared with a nominal value representing the control voltage (as) at nominal frequency of the oscillator, and in that the deviations from the nominal value of all evaluating intervals are added together and are supplied to a digital low-pass filter (TP) rectifying the accumulated deviations.

2. Method according to Claim 1, characterized in that the duration of the evaluating interval and the time constants or control rates of the filters and integrators are matched to one another in dependence on the frequency of the clock signals (its).

3. Method according to Claim 1, characterized in that the components of the phase-locked loop can be at least partially controlled and monitored by a central control device (ZST).

4. Method according to one of the preceding claims, characterized in that the central control device (ZST) is used for monitoring the existence of the reference and clock signals (nts, its) and in that a failure of clock signals is signalled or indicated.

5. Method according to one of the preceding claims, characterized in that the control device (ZST) is used for detecting and signalling or indicating the allocation of reference clock signals (nts), to the frequency of which the phase-locked loop cannot be synchronized.

6. Method according to one of the preceding claims, characterized in that the time interval clock signals (zts) are obtained from the reference clock signals (nts) by means of a dividing device (DIV), the division ratio of which can be varied.

7. Method according to one of the preceding claims, characterized in that the division ratio of the dividing device (DIV) can be varied by means of the central control device.

8. Method according to one of the preceding claims, characterized in that the frequency of the reference clock signals (nts) is determined by means of a frequency-measuring device and in that the division ratio for the dividing device (DIV) is determined and set by means of the central control device (ZST) in dependence on the value of the frequency determined.

9. Method according to Claim 1, characterized in that the clock signals are obtained from oscillator clock signals (its) conducted via a phase comparison device (PV) and a low-pass filter (F) connected in series therewith and an additional voltage-controlled crystal oscillator (ZVCO), in the sense of using the phase-locked loop as a highly-stabilised voltge-controlled oscillator or frequency multiplying device the output (A) of the counting device (Z) being connected to a comparator input (E) of the phase comparison device (PV).

10. Arrangement for carrying out the method according to one of Claims 1 to 9, characterized in that the phase-locked loop is formed by
- a voltage-controlled oscillator (VCO) generating the clock signals (its) and providing the clock signals (its) at its output (A),
- a counting device (Z) counting the clock signals (its) which is connected via its counting input (ZE) to the output (A) of the voltage-controlled oscillator (VCO) for this purpose,
- a register (R) following the counter (Z), into which a currently present count of the counter (Z) is transferred at times defined by the time interval clock signals (zts) and is stored, the time interval clock signals (zts) being supplied at its transfer input (ÜE),
- an arithmetic unit (AE) following the register (R), in which, in each evaluating interval representing a selectable number of time interval clock signals (zts), the difference between the current evaluating interval supplied and the preceding evaluating interval is formed and is compared with a nominal value representing the control voltage (as) at nominal frequency of the oscillator (VCO),
- a digital low-pass filter (TP) following the arithmetic unit (AE), in which filter the transferred, accumulated differences of the counts are rectified,
- a PI filter (PIF) following the digital low-pass filter (TP), in which the rectified, accumulated differences of the counts are integrated,
- an analog/digital converter (D/A) following the PI filter (PIF), in which the integrated, accumulated, rectified differences of the counts (DS) are converted into an analog oscillator control voltage (as), the output (A) of the analog/digital converter (A/D) being connected to the voltage input (SE) of the voltage-controlled oscillator (VCO),
- a dividing device (DIV), changing the frequency of the reference clock signals (nts), to the input (E) of which the reference clock signals (nts) are conducted and via the output (A) of which the time interval clock signals (zts) representing divided reference clock signals (nts) are conducted to the transfer input (ÜE) of the register (R),
- and a central controller (zst) with the aid of which the dividing factor and the defined output states in the components of the phase-locked loop are set via setting inputs (EE) arranged in the dividing device (DIV).

11. Arrangement according to Claim 10, characterized in that the functions allocated to the components of the phase-locked loop can be predominantly implemented by programs in a microprocessor system (MP).

12. Arrangement according to Claim 11, characterized in that the microprocessor system (MP) can be implemented by a 1-chip microprocessor (MP) with integrated A/D converter.

13. Arrangement according to Claim 10, characterized in that the functions allocated to the components of the phase-locked loop can be predominantly implemented in a customer-specified, integrated circuit.

## Revendications

1. Procédé pour déterminer la tension de commande (as) d'un oscillateur (VCO) d'une boucle de régulation de phase, qui est commandé en tension, selon lequel on compare la position de phase de signaux numériques de cadence de référence (nts) à celle de signaux de cadence (its) obtenus à partir de signaux de cadence de l'oscillateur, et on forme des signaux numériques de commande de l'oscillateur dans un dispositif formant processeur (MP) à l'aide du résultat de la comparaison de phase, signaux de commande qui sont redressés, intégrés et ensuite convertis, par l'intermédiaire d'un convertisseur numérique/analogique (A/D), en une tension analogique (as) de commande de l'oscillateur,
caractérisé par le fait
que l'on compte les signaux de cadence (its) dans un dispositif de comptage (Z), en aval duquel est branché un registre (R), que l'on envoie à une entrée de transfert (ÜE) du registre (R) des signaux de cadence d'intervalles de temps (zts), qui sont obtenus à partir des signaux de cadence de référence et qui ont une fréquence inférieure à celle des signaux de cadence (its), que l'on transfert et que l'on mémorise l'état présent du compteur dans le registre (R), à des instants définis par les signaux de cadence d'intervalles de temps (zts), que l'on envoie l'état mémorisé du compteur à un dispositif arithmétique (AE) et que dans ce dernier, pendant chaque intervalle d'évaluation représentant un nombre au choix de signaux de cadence d'intervalles de temps (zts), on forme la différence entre l'état présent du compteur et l'état du compteur pour l'intervalle d'évaluation précédent et on la compare à une valeur de consigne représentant la tension de commande (as) à la fréquence nominale de l'oscillateur, et que l'on somme les écarts par rapport à la valeur de consigne de tous les intervalles d'évaluation et on les envoie à un filtre passe-bas (TP) numérique, qui redresse les écarts sommés.

2. Procédé suivant la revendication 1,
caractérisé par le fait qu'en fonction de la fréquence des signaux de cadence (its) on accorde les unes sur les autres la durée des intervalles d'évaluation et les constantes de temps ou les vitesses de régulation des filtres et des intégrateurs.

3. Procédé suivant la revendication 1,
caractérisé par le fait que l'on peut commander et contrôler les composants du circuit de régulation de phase au moins en partie par un dispositif central de commande (ZST).

4. Procédé suivant l'une des revendications précédentes,
caractérisé par le fait que l'on contrôle la présence des signaux de référence et des signaux de cadence (nts, its) à l'aide du dispositif central de commande (ZST) et que l'on signale ou que l'on affiche une absence de signaux de cadence.

5. Procédé suivant l'une des revendications précédentes,
caractérisé par le fait que l'on identifie et signale ou affiche à l'aide du dispositif de commande (ZST) l'association de signaux de cadence de référence (nts), sur la fréquence desquelles le circuit de régulation de phase ne peut pas être synchronisé.

6. Procédé suivant l'une des revendications précédentes,
caractérisé par le fait que l'on obtient les signaux de cadence d'intervalles de temps (zts) à partir des signaux de cadence de référence (nts), au moyen d'un dispositif diviseur (DIV), dont le rapport de division peut être modifié.

7. Procédé suivant l'une des revendications précédentes,
caractérisé par le fait que l'on peut modifier le rapport de division du dispositif diviseur (DIV) à l'aide du dispositif central de commande.

8. Procédé suivant l'une des revendications précédentes,
caractérisé par le fait que l'on détermine la fréquence des signaux de cadence de référence (nts) à l'aide d'un dispositif de mesure de la fréquence, et que l'on détermine et que l'on règle le rapport de division du dispositif diviseur (DIV), en fonction de la valeur de la fréquence déterminée, à l'aide du dispositif central de commande (ZST).

9. Procédé suivant la revendication 1,
caractérisé par le fait que l'on obtient les signaux de cadence, en vue d'utiliser le circuit de régulation de phase en tant qu'oscillateur ou en tant que multiplicateur de fréquence très constant et commandé en tension, à partir de signaux de cadence (its) de l'oscillateur, envoyés par l'intermédiaire d'un dispositif de comparaison de phase (PV) ainsi que d'un filtre passe-bas (F) branché en série avec ce dispositif, et d'un oscillateur à quartz supplémentaire (ZVCO) commandé en tension, la sortie (A) du dispositif de comptage (Z) étant reliée à une entrée de comparaison (E) du dispositif de comparaison de phase (PV).

10. Dispositif pour la mise en oeuvre du procédé suivant l'une des revendications 1 à 9, caractérisé par le fait que le circuit de régulation de phase est formé par
- un oscillateur (VCO) qui est commandé en tension, qui produit les signaux de cadence (its) et qui délivre, à sa sortie (A), les signaux de cadence (its),
- un dispositif de comptage (Z), qui compte les signaux de cadence (its) et qui est relié, à cet effet, par l'intermédiaire de son entrée de comptage (ZE), à la sortie (A) de l'oscillateur (VCO) commandé en tension,
- un registre (R) qui est branché en aval du compteur (Z) et dans lequel un état actuellement présent du compteur (Z) est transféré et mémorisé aux instants définis par les signaux de cadence d'intervalle de temps (zts), les signaux de cadence d'intervalles de temps (zts) étant envoyés à une entrée de transfert (ÜE),
- un dispositif arithmétique (AE), qui est branché en aval du registre (R) et dans lequel, pendant chaque intervalle d'évaluation représentant un nombre pouvant être sélectionné de signaux de cadence d'intervalles de temps (zts), la différence entre l'intervalle d'évaluation actuel envoyé et l'intervalle de temps précédent est formée et est comparée à une valeur de consigne représentant la tension de commande (as) à la fréquence nominale de l'oscillateur (VCO),
- un filtre passe-bas numérique (TP), qui est branché en aval du dispositif arithmétique (AE) et dans lequel les différences transmises et sommées des états du compteur sont redressées,
- un filtre à action proportionnelle et intégrale (PIF), qui est branché en aval du filtre numérique (TP) et dans lequel les différences redressées et sommées des états du compteur sont intégrées,
- un convertisseur analogique/numérique (D/A), qui est branché en aval du filtre à action proportionnelle et intégrale (PIF) et dans lequel les différences intégrées, sommées et redressées des états (DS) du compteur sont converties en une tension analogique de commande (as) de l'oscillateur, la sortie (A) du convertisseur analogique/numérique (A/D) étant reliée à l'entrée de tension (SE) de l'oscillateur (VCO) commandé en tension,
- un dispositif diviseur (DIV), qui modifie la fréquence des signaux de cadence de référence (nts) et à l'entrée (E) duquel sont envoyés les signaux de cadence de référence (nts), et au moyen de la sortie (A) duquel les signaux de cadence d'intervalles de temps (zts), qui représentent les signaux de cadence de référence divisés (nts), sont envoyés à l'entrée de transfert (ÜE) du registre (R), et
- une unité de commande centrale (ZST), à l'aide de laquelle le facteur de division et les états initiaux définis sont réglés dans les composants du circuit de régulation de phase, par l'intermédiaire d'entrées de réglage (EE) disposées dans le dispositif diviseur (DIV).

11. Dispositif suivant la revendication 10, caractérisé par le fait que les fonctions associées aux composants du circuit de régulation de phase, peuvent être réalisées dans une large mesure au moyen de programmes dans un système à microprocesseur (MP).

12. Dispositif suivant la revendication 11, caractérisé par le fait que le système à microprocesseur (MP) peut être réalisé par un microprocesseur monopuce (MP) comportant un convertisseur analogique/numérique intégré.

13. Dispositif suivant la revendication 10, caractérisé par le fait que les fonctions associées aux composants du circuit de régulation de phase peuvent être réalisées dans une large mesure dans un circuit intégré spécifié pour le client.
